# EUROPEAN PATENT APPLICATION

(11) **EP 1 081 861 A2**
(43) Date of publication of application: **07.03.2001**
(21) Application number: 00116959.8
(22) Date of filing: 07.08.2000
(51) Int. Cl.: H03M 1/10, H03M 1/12

(54) **Gain calibration system and method for creating matched A/D converters**

(30) Priority: 31.08.1999 US 387005
(71) Applicant: Agilent Technologies Inc., A Delaware Corporation, Palo Alto, CA 94306-2024 (US)
(72) Inventor: Brosnan, Michael, Fremont, CA 94536 (US); Hidai, Takashi, Palo Alto, CA 94303 (US); McJimsey, Michael D., Danville, CA 94506 (US); Muscha, Leslie, Sunnyvale, CA 94086 (US)
(74) Representative: Schoppe, Fritz, Dipl.-Ing.

(57) **Abstract**

A system (10) and method for matching the gains of first and second analog-to-digital converters (54) and (56). In a most general sense, the inventive system includes a controller for sensing the output of the first converter (54) and the second converter (56). A microprocessor or digital state machine (30) computes a correction factor in response to the outputs of the first and second converters (54) and (56). The correction factor is used to adjust the gain of the second converter (56) to match that of the first converter (54) in accordance with the needs of a particular application. In the illustrative embodiment, the A/D converters are provided by isolated modulators and digital filters.

## Description

### BACKGROUND OF THE INVENTION

### Field of the Invention:

The present invention relates to analog-to-digital (A/D) converters. More specifically, the present invention relates to systems and methods for matching the outputs of two or more A/D converters.

### Description of the Related Art:

For many applications, there is a requirement to match the outputs of two or more A/D converters. One such application involves industrial motor control. Motors used in factories are typically servo-controlled and driven with three-phase currents. At one time, Hall effect sensors were used to measure the current flowing in the power lines feeding the motor. These devices allowed for the gain and offset to be manually controlled on each channel to optimized motor performance. Unfortunately, Hall effect devices are generaily large, heavy, expensive devices which are hard to solder onto a circuit board.

Accordingly, isolated analog-to-digital converters and amplifiers were developed to replace Hall effect devices for motor control applications. While these devices were smaller and less expensive, they did not achieve the high gain matching performance of Hall effect devices.

Subsequently, techniques were developed to improve the gain matching performance of the isolated A/D converters. One technique provided for an adjustment of an analog voltage on each of the chips that are performing an A/D conversion on each of the signal wires feeding voltage levels hack to a controller. However, this approach is expensive, requires manual adjustment after the unit is installed in the motor and is somewhat hazardous.

Hence, a need remains in the art for an inexpensive system or technique for automatically matching outputs of A/D converters.

### SUMMARY OF THE INVENTION

The need in the art is addressed by the system and method for matching the outputs of first and second analog-to-digital converters of the present invention. In a most general sense, the inventive system includes a mechanism for sensing the output of the first converter and a mechanism for sensing the output of the second converter. A microprocessor runs software that computes a correction factor in response to the outputs of the first and second converters. The correction factor is used to adjust the output of the second converter to match the gain of the first converter in accordance with the needs of a particular application.

In the illustrative embodiment, the correction factor is such that the gain of said second converter is equal to that of the first converter and the software includes code for adjusting the gain of the second converter to be greater than or equal to the output of the first converter. In the illustrative embodiment, the analog inputs to the A/D converters are provided by series sense resistors.

### BRIEF DESCRIPTION OF THE DRAWINGS

Fig. 1 is a schematic/block diagram of an illustrative implementation of an application of a system for matching the gains of first and second analog-to-digital converters constructed in accordance with conventional teachings.
Fig. 2 is a schematic/block diagram of an illustrative application of a system for matching the gains of first and second analog-to-digital converters constructed in accordance with the teachings of the present invention.
Fig. 3 is block diagram of the isolated A/D converters of the system for matching the outputs of first and second analog-to-digital converters constructed in accordance with the teachings of the present invention.
Fig. 4a is a flow diagram of a calibration method for the system for matching the outputs of first and second analog-to-digital converters implemented in accordance with the teachings of the present invention.
Fig. 4b is a flow diagram of a normal method of operation for the system for matching the gains of first and second analog-to-digital converters implemented in accordance with the teachings of the present invention.

### DESCRIPTION OF THE INVENTION

Illustrative embodiments and exemplary applications will now be described with reference to the accompanying drawings to disclose the advantageous teachings of the present invention.

While the present invention is described herein with reference to illustrative embodiments for particular applications, it should be understood that the invention is not limited thereto. Those having ordinary skill in the art and access to the teachings provided herein will recognize additional modifications, applications, and embodiments within the scope thereof and additional fields in which the present invention would be of significant utility.

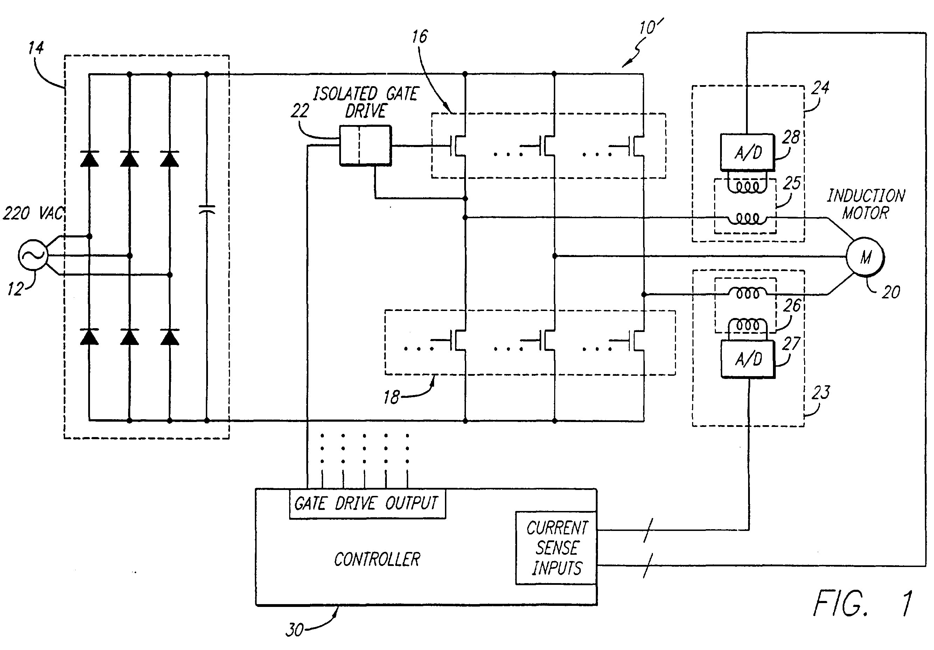

Fig. 1 is a schematic/block diagram of an illustrative implementation of an application of a system for matching the gains of first and second analog-to-digital converters constructed in accordance with conventional teachings. As shown in Fig. 1, in a typical motor drive system 10', current from a three-phase source 12 is rectified to direct current (DC) by a diode rectifier circuit 14. The DC current is applied as a level adjusted, simulated, three-phase current to an induction motor 20 via a plurality of drive transistors 16 and 18. A controller 30 supplies gate drive voltage to the drive transistors 16 and 18 via isolated gate drive circuits 22 and adjusts the level of same (and thereby the speed of the motor 20) via isolated current sensing circuits 23 and 24. In practice, the current sensing was effected with Hall effect devices 25 and 26. The analog current sensed by the Hall effect devices 25 and 26 was converted to a digital voltage by variable analog to digital converters 27 and 28. The digitized voltages were used by the controller to adjust the timing, speed and direction of actuation of the motor 20.

As mentioned above, the conventional implementation of Fig. 1, required an adjustment of the analog voltage on each of the chips performing the A/D conversions feeding back to the controller 30. As this approach was expensive, required manual adjustment after the unit was installed in the motor and was somewhat hazardous, a need remained in the art for an inexpensive system or technique for automatically matching gains of A/D converters.

As discussed more fully below, the need in the art is addressed by the system and method for matching the gains of first and second analog-to-digital converters of the present invention.

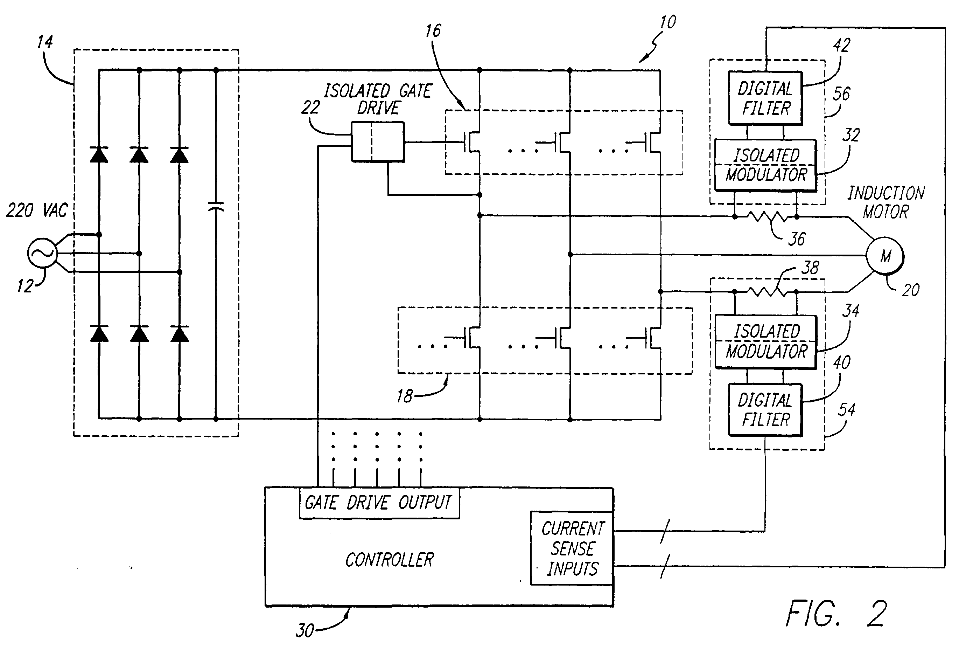

Fig. 2 is a schematic/block diagram of an illustrative application of a system for matching the gains of first and second analog-to-digital converters constructed in accordance with the teachings of the present invention. The system 10 is similar to the system 10' of Fig. 1 with the exception that the inventive system 10 includes isolated modulators 32 and 34 which form first and second A/D converters when combined with digital filters 40 and 42.

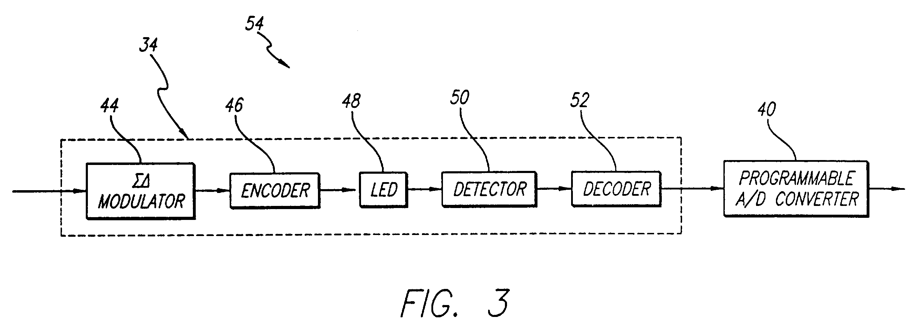

Fig. 3 is block diagram showing the isolated modulator and A/D converter of Fig 2 in greater detail. The isolated modulators may be purchased from Hewlett Packard as HCPL 7860. As disclosed more fully in the attached data sheet, the modulators 32 and 34 include a ΣΔ modulator 44, an encoder 46 and a light emitting diode 48. The voltage sensed by the modulator 44 is converted to light by the diode 48. The light output by the diode 48 is sensed by a detector 50 and decoded by a decoder 52. The output of the decoder is the output of the modulator 32 or 34 and input to an associated digital filter 40 or 42. The digital filter completes the programmable A/D converter 54. The converter 54 is programmable in response to a signal received from the controller 30. The digital filter may be purchased from Hewlett Packard as HCPL 7870. While those skilled in the art will understand how to effect microprocessor control of the filters 40 and 42, a data sheet is provided in the enclosed appendix to facilitate an understanding of same.

Returning to Fig. 2, the controller 30 receives and senses the ouputs of the first and second A/D converters 54 and 56. The controller includes a microprocessor, which runs software that computes a correction factor in response to the outputs of the first and second converters 54 and 56. As discussed more fully below, the correction factor is used 10 adjust the output of the second converter 56 to match that of the first converter 54 in accordance with the needs of a particular application.

In operation, the method of the present invention takes advantage of the fact that in a 3-phase inverter motor drive with 2 phase current sensors, it is possible to deliver equal magnitude currents to the two sensors. This can be done by not turning on the 3rd phase, forcing all current to flow into phase (channel) 1 and out phase 2. For a one-time factory calibration this current can be a DC current from an external power supply. For a power-up gain calibration this current can arise by applying a fixed voltage pulse across phases 1 and 2 noting that the motor inductance will cause a linear ramp of current vs. time.

By performing a simultaneous measurement on both phases, gain mismatch is evaluated. An offset calibration should be performed before gain calibration for best accuracy. By evaluating the gain mismatch, appropriate correction factors can be determined in a manner described below.

Several methods are available for choosing the best correction values during the calibration phase.

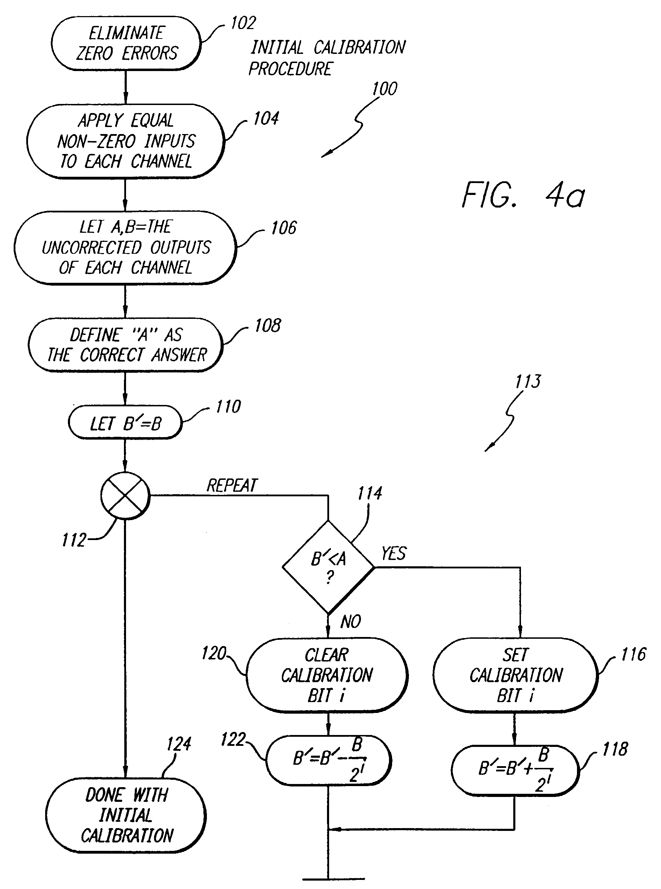

Fig. 4a is a flow diagram of an illustrative calibration method for the system for matching the outputs of first and second analog-to-digital converters implemented in accordance with the teachings of the present invention. The calibration method 100 includes the steps of eliminating zero errors 102. Next, at step 104, equal nonzero inputs are applied to two of the three windings (channels) by the controller 30. At step 106, the uncorrected outputs of the two channels are denoted as A and B. At step 108, A is arbitrarily defined as the correct value. At step 110, a parameter B' is set equal to B.

At step 112 a routine 113 is executed for a number of times *i* = 3 to 8. As will be appreciated by those of ordinary skill in he art, in practice, the range of index *i* is set by a tradeoff between accuracy and speed. The routine 113 includes a decision step 114 which compares the value of B' to A. If B' is less than A, then at step 116, a calibration bit *i* is set. Then, at step 118, B' is incremented by B/2^{*i*} and the routine returns to step 114.

If at step 114, B' is not less than A, then at step 120, the calibration bit is cleared and B' is decremented by B/2^{*i*} and the routine returns to step 114.

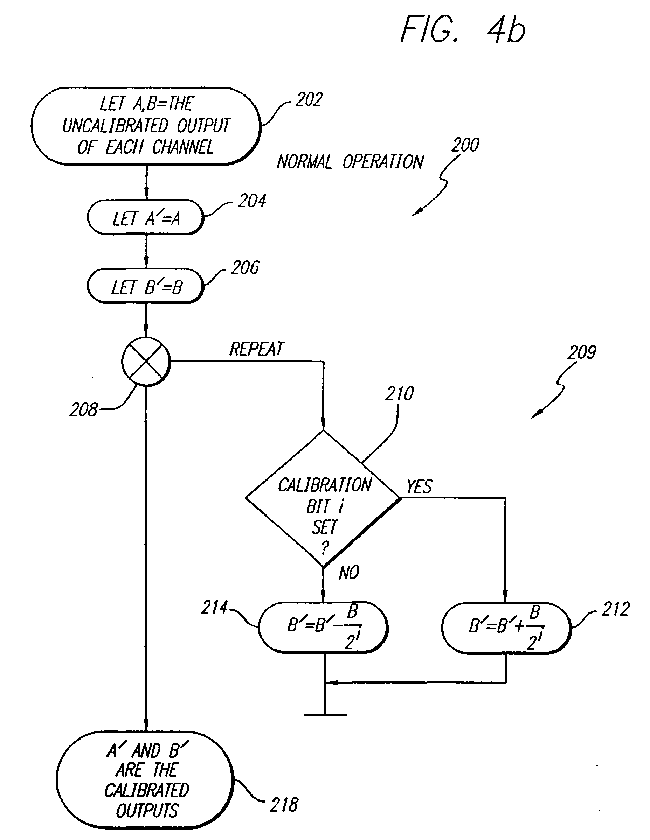

At step 124, the calibration of the system 10 is complete and the system goes to normal operational mode 200 depicted in Fig. 4b.

Fig. 4b is a flow diagram of a normal method of operation for the system 10 of the present invention. At step 202, A and B are denoted the uncalibrated outputs of each channel. At steps 204 and 206, a parameter A' is set equal to A and B' is set equal to B, respectively. At step 208, a routine 209 is executed for a number of times *i* = 3 to 8. At step 210, the calibration bit is checked to determine if it has been set. If so, at step 212, B' is incremented by B/2^{*i*} and the routine returns to step 210. If the calibration bit is not set, at step 214, B' is decremented by B/2^{*i*} and the routine returns to step 218. At step 218, A' and B' are the calibrated outputs.

These calibrated outputs compensate for gain errors in the A/D converters 54 and 56 to drive the motor 20 with balanced inputs.

Thus, the present invention has been described herein with reference to a particular embodiment for a particular application. Those having ordinary skill in the art and access to the present teachings will recognize additional modifications, applications and embodiments within the scope thereof.

It is therefore intended by the appended claims to cover any and all such applications, modifications and embodiments within the scope of the present invention.

## Claims

1. A system (10) for matching the outputs of first and second analog-to-digital converters (54) and (56) characterized by:
a state machine (30) for sensing the outputs of the converters (54) and (56) and for computing a correction factor in response to the outputs of the first and second converters (54) and (56) and
a mechanism responsive to the correction factor for adjusting the output of the second converter (56).

2. The invention of Claim 1 wherein said correction factor is such that the gain of said second converter (56) is equal to that of the first converter (54).

3. The invention of Claim 2 wherein said state machine includes code for adjusting the gain of the second converter (56) to be greater than or equal to the gain of the first converter (54).
